**Europäisches Patentamt**

**European Patent Office**

**Office européen des brevets**

(19)

(11) Veröffentlichungsnummer: **0 064 715**
**B1**

(12) # EUROPÄISCHE PATENTSCHRIFT

(45) Veröffentlichungstag der Patentschrift:
**11.03.87**

(51) Int. Cl.⁴: **H 01 L 29/74**

(21) Anmeldenummer: **82103778.5**

(22) Anmeldetag: **03.05.82**

(54) Thyristor mit in den Emitter eingefügten steuerbaren Emitter-Kurzschlusspfaden.

(30) Priorität: **08.05.81 DE 3118365**

(43) Veröffentlichungstag der Anmeldung:
**17.11.82 Patentblatt 82/46**

(45) Bekanntmachung des Hinweises auf die Patenterteilung:
**11.03.87 Patentblatt 87/11**

(84) Benannte Vertragsstaaten:
**CH FR GB IT LI SE**

(56) Entgegenhaltungen:
**EP - A - 0 028 797**
**EP - A - 0 028 798**
**EP - A - 0 029 163**
**EP - A - 0 030 274**
**EP - A - 0 039 941**
**DE - A - 2 625 912**
**DE - A - 2 947 669**
**US - A - 3 243 669**

(73) Patentinhaber: *Siemens Aktiengesellschaft Berlin und München, Wittelsbacherplatz 2, D-8000 München 2 (DE)*

(72) Erfinder: **Spenke, Eberhard, Dr., Siemensstrasse 1, D-8551 Pretzfeld (DE)**
Erfinder: **Patalong, Hubert, Dr., Kurt-Flöricke-Strasse 18, D-8000 München 60 (DE)**

**Beschreibung**

Die Erfindung bezieht sich auf einen Thyristor nach den Oberbegriffen der Patentansprüche 1 oder 2 und auf Verfahren zu seinem Betrieb.

Thyristoren dieser Art sind aus der US-A-3 243 669, vgl. insbesondere Fig. 9, und aus dem DE-A1-2 625 917 bekannt. Sie weisen MIS-FET-Strukturen auf, die jeweils aus einem ersten Halbleitergebiet eines ersten Leitungstyps, das mit einer ersten Elektrode des Thyristors verbunden ist, einem zweiten Halbleitergebiet des ersten Leitungstyps, das mit der an den jeweiligen Emitter angrenzenden Basisschicht verbunden ist, und einem zwischen diesen Halbleitergebieten liegenden Halbleiterbereich des zweiten Leitungstyps bestehen, der von einem gegenüber dem Halbleiterkörper elektrisch isolierten Gate überdeckt ist. Über diese Strukturen verlaufen Emitter-Kurzschlusspfade, die über die Gates der Strukturen steuerbar sind. Bei der US-A-3 243 669 werden die Emitter-Kurzschlusspfade lediglich zum Löschen des Thyristors wirksam geschaltet. Bei dem DE-A1-2 625 917 werden sie sowohl zum Zwecke des Löschens wirksam geschaltet als auch während des Zuführens eines Zündimpulses, um eine Zündung des Thyristors zu verhindern.

Weitere Thyristoren mit steuerbaren Emitter-Kurzschlusspfaden sind z.B. in DE-A1-2 945 366 und DE-A1-2 945 324 beschrieben.

Um den pn-Übergang zwischen dem Emitter und der angrenzenden Basisschicht wirksam kurz zu schliessen, ist es bei den obengenannten Thyristoren vorteilhaft, die steuerbaren Emitter-Kurzschlusspfade möglichst grossflächig auszubilden. Zu diesem Zweck wird der Emitter in mehrere Emitterteilgebiete aufgeteilt, die dann jeweils von MIS-FET-Strukturen vollständig oder fast vollständig umgeben sind. Damit kann aber derjenige Teil des Thyristorquerschnitts, der auf die Zwischenräume zwischen den einzelnen Emitterteilgebieten und auf die MIS-FET-Strukturen entfällt, im Durchlasszustand des Thyristors keinen Laststromanteil übernehmen.

Der Erfindung liegt die Aufgabe zugrunde, einen Thyristor der eingangs genannten Art anzugeben, der mit sehr wirkungsvollen, aber flächensparenden Emitter-Kurzschlusspfaden versehen ist. Das wird erfindungsgemäss durch eine Ausbildung des Thyristors nach den kennzeichnenden Teilen des Patentanspruchs 1 oder des Patentanspruchs 2 erreicht.

Der mit der Erfindung erzielbare Vorteil besteht insbesondere darin, dass die Emitter-Kurzschlusspfade trotz ihrer Effektivität einen wesentlich geringeren Teil des Thyristorquerschnitts beanspruchen, als das bei den herkömmlich ausgebildeten Thyristoren der Fall ist.

Die Patentansprüche 2 bis 8 geben vorteilhafte Ausgestaltungen und Weiterbildungen der Erfindung an, während die Patentansprüche 9 und 10 auf vorteilhafte Verfahren zum Betrieb von erfindungsgemässen Thyristoren gerichtet sind.

Die Erfindung wird nachfolgend anhand der Zeichnung näher erläutert. Dabei zeigen:

Fig. 1 ein erstes Ausführungsbeispiel der Erfindung,

Fig. 2 eine weitere Darstellung des ersten Ausführungsbeispiels,

Fig. 3 eine andere Ausgestaltung einer Teilschaltung von Fig. 1,

Fig. 4 eine weitere Ausgestaltung dieser Teilschaltung von Fig. 1,

Fig. 5, Fig. 6 und Fig. 7 Spannungs-Zeit-Diagramme zur Erläuterung von Fig. 1,

Fig. 8 und Fig. 9 eine weitere Teilschaltung von Fig. 1,

Fig. 10 ein zweites Ausführungsbeispiel der Erfindung,

Fig. 11 eine weitere Darstellung dieses Ausführungsbeispiels,

Fig. 12 ein drittes Ausführungsbeispiel,

Fig. 13 ein viertes Ausführungsbeispiel und

Fig. 14 ein fünftes Ausführungsbeispiel der Erfindung.

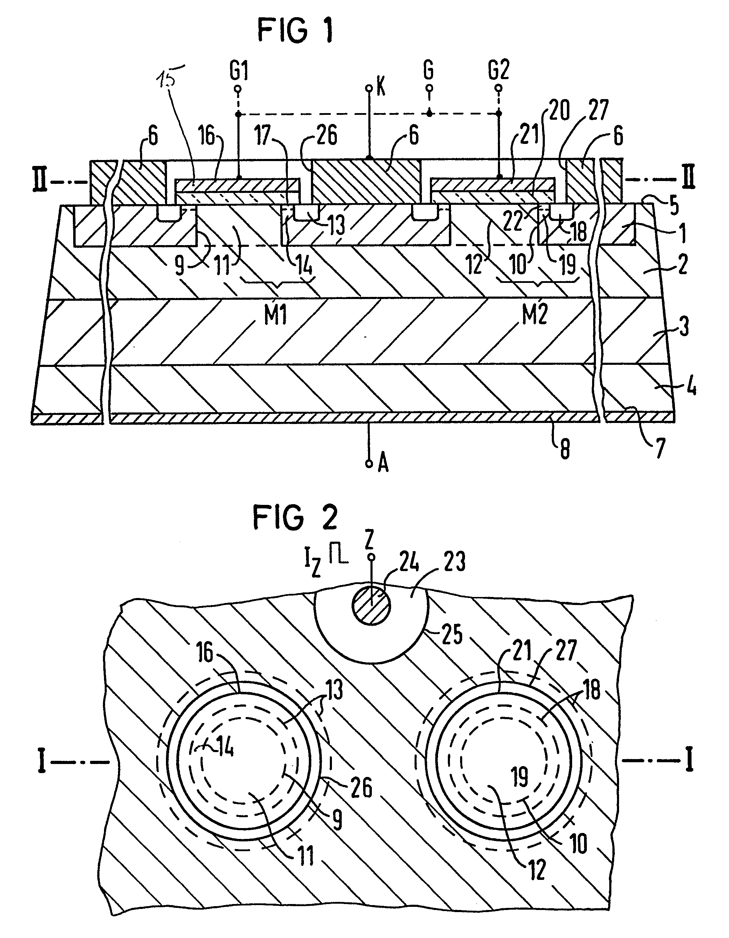

In Fig. 1 ist ein Thyristor mit einem aus dotiertem Halbleitermaterial, z.B. Silizium, bestehenden Halbleiterkörper dargestellt, der vier aufeinanderfolgende Schichten abwechselnder Leitungstypen aufweist. Dabei bezeichnet man eine n-leitende Schicht 1 als den n-Emitter, eine p-leitende Schicht 2 als die p-Basisschicht, eine n-leitende Schicht 3 als die n-Basisschicht und eine p-leitende Schicht 4 als den p-Emitter. Der n-Emitter 1 ist an einer Grenzfläche 5 des Halbleiterkörpers mit einer ersten Elektrode (Kathode) 6 aus elektrisch leitendem Material, z.B. Aluminium, belegt, die einen Anschluss K aufweist. Der p-Emitter 4 wird an der gegenüberliegenden Grenzfläche 7 des Halbleiterkörpers von einer zweiten Elektrode (Anode) 8 aus elektrisch leitendem Material, z.B. Aluminium, kontaktiert. Die zweite Elektrode 8 ist mit einem Anschluss A versehen.

Im n-Emitter 1 sind Ausnehmungen 9 und 10 vorgesehen. Die kreisförmigen lateralen Begrenzungen dieser Ausnehmungen sind der Fig. 2 entnehmbar, die einen Schnitt durch den Thyristor in der Ebene II–II von Fig. 1 zeigt. Die Ausnehmungen 9, 10 werden von ansatzartigen Teilen 11 und 12 der p-Basisschicht 2 durchdrungen, die sich bis zur Grenzfläche 5 erstrecken. Die Ausnehmung 9 ist lateral von einem ringförmigen p-leitenden Halbleitergebiet 13 umschlossen, das in den n-Emitter 1 eingefügt ist und sich bis zu der Grenzfläche 5 des Halbleiterkörpers erstreckt. Zwischen dem inneren Rand des p-leitenden Halbleitergebiets 13 und dem Teil 11 der p-Basisschicht 2 liegt ein ringförmiges Randgebiet 14 des n-Emitters 1, das von einer auf der Grenzfläche 5 aufgebrachten, dünnen, elektrisch isolierenden Schicht 15 überdeckt ist. Auf dieser ist ein Gate 16 aus elektrisch leitendem Material, z.B. Aluminium, aufgebracht, das mit einem Steueranschluss G1 verbunden ist. Die Teile 11, 13, 14, 15 und 16 bilden eine MIS-FET-Struktur M1 des Verarmungstyps, wobei 13 und 11 jeweils erste und zweite p-leitende Halbleitergebiete darstellen, die durch einen aus dem Randgebiet 14 bestehenden n-leitenden Halbleiterbereich voneinander getrennt sind. Bei spannungslosem Gate 16 ist in dem unmittelbar an der Grenzfläche 5 liegenden Teil der Randzone 14 ein p-leitender Kanal 17 vorhanden, der die Halbleitergebiete 11 und 13 niederohmig miteinander verbindet. Über die Teile 11, 17, 13 und 6 verläuft dabei ein Emitter-Kurzschlusspfad, der den pn-Übergang zwischen 1 und 2 niederohmig überbrückt. Bei dem Kanal 17 kann es sich entweder um einen Inversionskanal handeln, der durch ein an der Grenzfläche 5 herrschendes elektrisches Feld hervorgerufen wird, oder um ein dotiertes Kanalgebiet (metallurgischer Kanal), das durch eine flache p-Dotierung in das Randgebiet 14 eingefügt ist. Führt man dem Steueranschluss G eine positive Spannung zu, so wird der Kanal 17 beseitigt oder hochohmig geschaltet, so dass der Emitter-Kurzschlusspfad unwirksam ist.

Im Bereich der Ausnehmung 10 sind in analoger Weise ein diese lateral umschliessendes p-leitendes Halbleitergebiet 18, ein Randgebiet 19 des n-Emitters 1, eine elektrisch isolierende Schicht 20, ein mit dem Steueranschluss G2 verbundenes Gate 21 und ein Kanal 22 vorhanden, die zusammen mit dem ansatzartigen Teil 12 der p-Basisschicht 2 eine MIS-FET-Struktur M2 des Verarmungstyps bilden. Über diese verläuft ein Emitter-Kurzschlusspfad, der aus den Teilen 12, 22, 18 und 6 besteht.

Innerhalb einer Kreisfläche 23 ist die p-Basisschicht 2 weder von der n-Emitterschicht 1 noch von der ersten Elektrode 6 bedeckt, sondern reicht bis zur Grenzfläche 5. Sie ist dort mit einer Zündelektrode 24 versehen, die einen Anschluss Z für einen Zündstromkreis aufweist.

Die Elektrode 6 weist Ausnehmungen 26 und 27 auf, die so dimensioniert sind, dass die von den Halbleitergebieten 13 und 18 eingeschlossenen Teile der Grenzfläche 5 einschliesslich der inneren Randbereiche der Halbleitergebiete 13 und 18 von der Elektrode 6 nicht kontaktiert werden. Da Fig. 1 einen Schnitt durch den Thyristor in der Ebene I–I von Fig. 2 zeigt, sind in Fig. 1 nur die Ausnehmungen 26 und 27 der Elektrode 6 erkennbar, dagegen nicht die Ausnehmung 25 für die Zündelektrode. Fig. 2 zeigt nur einen die MIS-Strukturen M1 und M2 und die Zündelektrode 24 unmittelbar umgebenden Teil des Halbleiterkörpers.

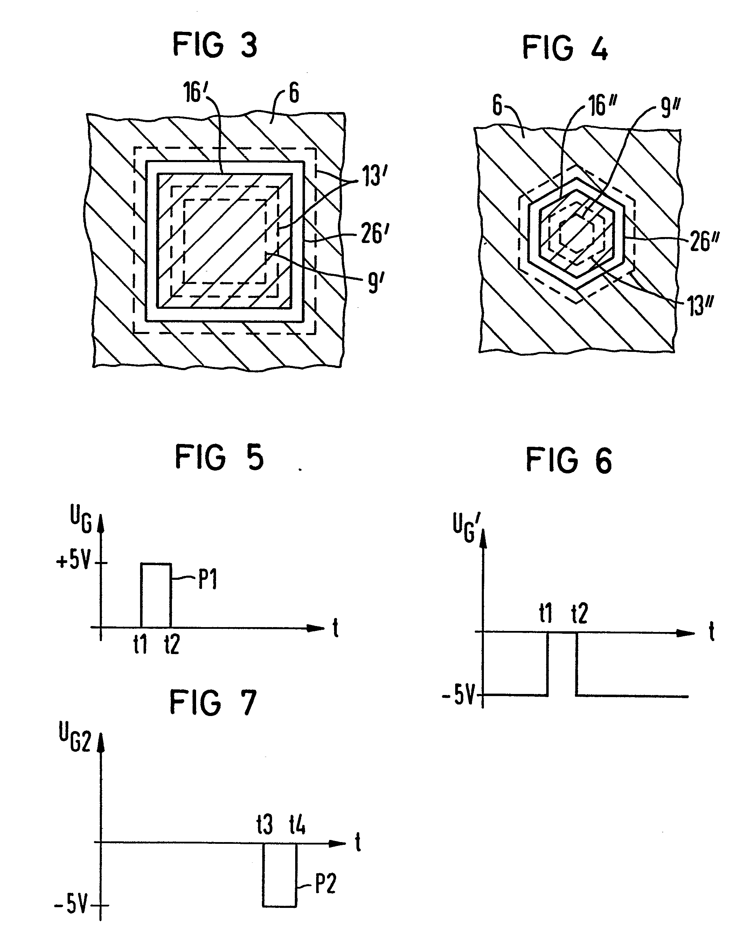

Die Figuren 3 und 4 geben alternative Ausgestaltungen einer MIS-FET-Struktur M1 oder M2 an. In Fig. 3 ist eine quadratische Ausnehmung 9′ des n-Emitters 1 dargestellt, die von einem entsprechend geformten n-leitenden Halbleitergebiet 13′ umschlossen wird. Die Ausnehmung 26′ der Elektrode 6 und das Gate 16′ sind hierbei ebenfalls quadratisch ausgeformt. Fig. 4 zeigt eine sechseckige Form der Ausnehmung 9″ und hieran angepasste Schaltungsteile 13″, 16″ und 26″, die den mit gleichen Ziffern bezeichneten Teilen der Fig. 2 entsprechen.

Der Thyristor nach Fig. 1 weist eine Mehrzahl von MIS-FET-Strukturen M1, M2 ... auf, die mit Vorteil möglichst gleichmässig über die Querschnittsfläche verteilt sind, d.h. möglichst gleich grosse Abstände voneinander haben. Nach einer ersten Schaltungsvariante sind die Gates aller dieser MIS-FET-Strukturen mit einem gemeinsamen Steueranschluss G verbunden, wie in Fig. 1 dargestellt ist. Im Betrieb ist dann der Steueranschluss G jeweils vor dem Zündzeitpunkt von Spannungen freigeschaltet. Dabei sind die Emitter-Kurzschlusspfade, z.B. 11, 17, 13, 6 jeweils wirksam geschaltet. Hierdurch wird eine Stabilität des Thyristors gegenüber unbeabsichtigten Zündvorgängen gewährleistet. Die steuerbaren Emitter-Kurzschlusspfade sämtlicher Strukturen stellen in diesem Fall Stabilitätskurzschlüsse dar.

Zum Zünden des Thyristors wird dem Anschluss Z ein positiver Zündstromimpuls $I_z$ zugeführt, während gleichzeitig der Steueranschluss G für die Dauer des Zündvorgangs mit einem positiven Spannungsimpuls beaufschlagt wird, der die p-Kanäle 17, 22 usw. jeweils unterbricht und damit die Stabilisierungskurzschlüsse während des gesamten Zündvorganges unwirksam schaltet.

Fig. 5 zeigt den zeitlichen Verlauf einer Steuerspannung $U_G$, die dem Steueranschluss G im Betrieb zugeführt wird. Wie hieraus hervorgeht, bleibt G spannungslos bis auf ein Zeitintervall t1 bis t2, in dem der Zündvorgang abläuft. In diesem Intervall liegt ein Spannungsimpuls P1 von z.B. +5V an G. Damit wird die Zündempfindlichkeit des Thyristors im Zeitintervall t1 bis t2 wesentlich erhöht. Nach erfolgter Zündung fliesst ein Laststrom eines bei A und K angeschlossenen Laststromkreises über den niederohmig geschalteten Thyristor. Die Abschaltung des letzteren wird durch eine Abschaltung der an A und K liegenden Spannung, oder, wenn es sich hierbei um eine Wechselspannung handelt, durch den nächstfolgenden Nulldurchgang derselben erreicht.

Der positive Spannungsimpuls P1 kann mit Vorteil aus der Zündspannung abgeleitet werden, die bei Zuführung des Zündstromimpulses $I_z$ am Anschluss Z auftritt. Zu diesem Zweck werden die Anschlüsse Z und G miteinander verbunden.

Sind die MIS-FET-Strukturen M1, M2 ... als solche des Anreicherungstyps ausgebildet, so wird dem Steueranschluss G eine Steuerspannung $U_G'$ zugeführt, deren Zeitabhängigkeit in Fig. 6 veranschaulicht ist. Danach liegt an dem Steueranschluss G vor dem Zündzeitpunkt t1, d.h. also im blockierenden Zustand des Thyristors, eine negative Spannung von z.B. -5V, welche p-leitende Inversionskanäle 17, 22 ... hervorruft und die Stabilisierungskurzschlüsse somit wirksam macht. Lediglich im Zeitintervall t1 bis t2, d.h. während des Zündvorganges, wird die Spannung $U_G'$ unterbrochen. Damit wird die bereits beschriebene Betriebsweise erreicht.

Nach einer zweiten Schaltungsvariante des Thyristors nach Fig. 1 sind die Gates einer ersten Gruppe von MIS-FET-Strukturen alle mit dem Steueranschluss G1 verbunden, während die Gates einer zweiten Gruppe, die eine wesentlich grössere Anzahl solcher Strukturen umfasst, alle mit dem Steueranschluss G2 beschaltet sind. Die zweite Gruppe kann beispielsweise hundertmal soviel MIS-FET-Strukturen umfassen als die erste. Hierbei sind die Strukturen der ersten Gruppe mit Vorteil als solche des Verarmungstyps ausgebildet und werden mit einer dem Steuereingang G1 zugeführten Steuerspannung $U_G$ nach Fig. 5 beaufschlagt, während die Strukturen der zweiten Gruppe dem Anreicherungstyp angehören und über G2 mit einer Steuerspannung $U_{G2}$ beaufschlagt werden, deren Zeitabhängigkeit in Fig. 7 dargestellt ist. Danach ist G2 im blockierenden Zustand des Thyristors, während des Zündvorgangs und im gezündeten Zustand jeweils spannungslos und wird nur während des Löschvorgangs, d.h. im Zeitintervall t3 bis t4, mit einem negativen Impuls P2 mit einer Amplitude von z.B. -5V beaufschlagt. Die zu dieser zweiten Gruppe gehörenden Emitter-Kurzschlusspfade werden dann wirksam und wirken als sog. Löschkurzschlüsse; durch sie werden die die Basisschichten 2 und 3 im gezündeten Zustand überschwemmenden Defektelektronen möglichst rasch zur Kathode 6 abgeleitet. Der Thyristor wird möglichst rasch gelöscht.

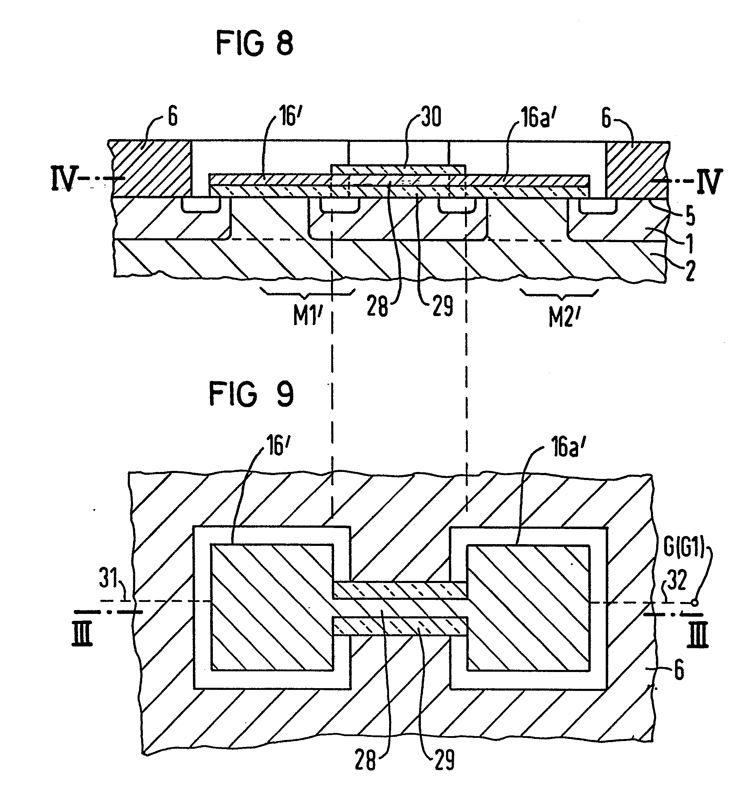

Die Figuren 8 und 9 zeigen eine Teilstruktur des Thyristors nach Fig. 1, die zur niederohmigen Verbindung der Gates zweier einander benachbarter MIS-FET-Strukturen dient. Die Schnittdarstellungen der Figuren 8 und 9 entsprechen den Ebenen III–III und IV–IV, wobei im Unterschied zu Fig. 2 von quadratisch ausgeformten Strukturen gemäss Fig. 3 ausgegangen wird. Wie aus den Figuren 8 und 9 hervorgeht, sind die Gates 16′ und 16a′ zweier MIS-FET-Strukturen M1′ und M2′ über eine Leiterbahn 28 aus einem elektrisch leitenden Material, z.B. Aluminium, miteinander verbunden, die durch eine dünne, elektrisch isolierende Schicht 29 von der Grenzfläche 5 getrennt ist. Die Leiterbahn 28 kann durch eine weitere Isolierschicht 30 abgedeckt sein. Die übrigen Teile der Figuren 8 und 9 entsprechen den mit gleichen Bezugszeichen versehenen Teilen der Figuren 1 und 2. Durch eine gestrichelt eingezeichnete Verbindungsleitung 31 soll angedeutet sein, dass das Gate 16′ über eine weitere solche Leiterbahn mit dem Gate einer weiteren MIS-FET-Struktur, insbesondere einer solchen der gleichen Gruppe, verbunden ist. Eine gestrichelte Leitung 32 deutet an, dass das Gate 16a′ über eine andere Leiterbahn mit einem der Steueranschlüsse G oder G1 bzw. G2 verbunden ist.

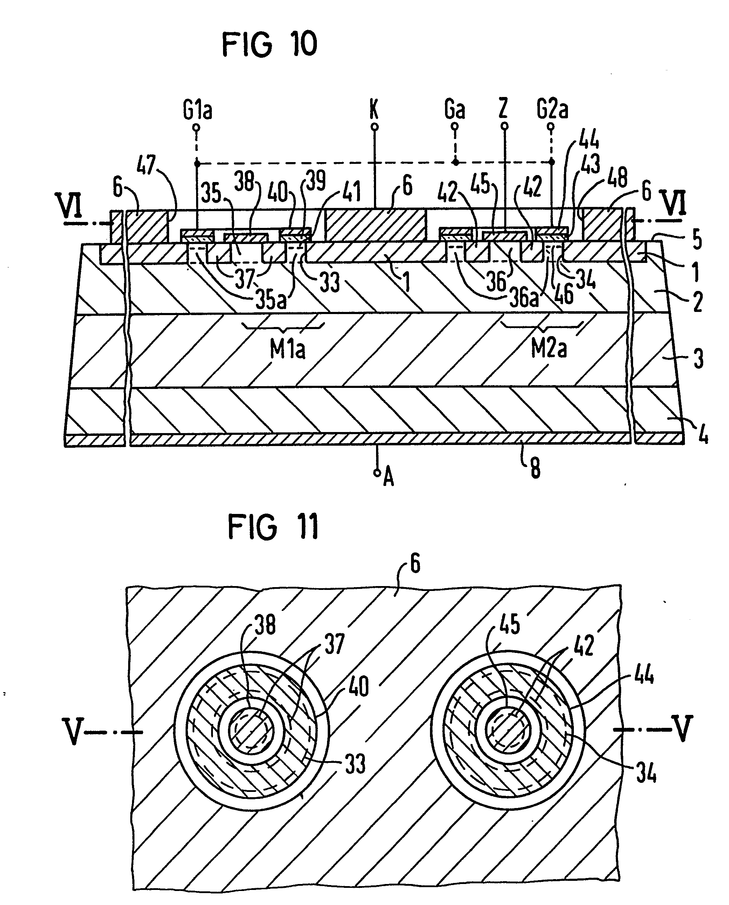

Die Figuren 10 und 11 zeigen einen zweiten nach der Erfindung ausgeführten Thyristor, der wieder einen n-Emitter 1, eine p-Basisschicht 2, eine n-Basisschicht 3 und einen p-Emitter 4 aufweist. Die Elektroden 6 und 8 entsprechen den gleichbezeichneten Elektroden von Fig. 1. Die Fig. 10 zeigt einen Schnitt durch den Thyristor in der Ebene V–V von Fig. 11, während Fig. 11 einen Schnitt durch einen Teil des Thyristors in der Ebene VI–VI von Fig. 10 darstellt.

Bei diesem Ausführungsbeispiel sind im schichtförmigen n-Emitter 1 Ausnehmungen 33 und 34 mit kreisförmigen lateralen Begrenzungen vorgesehen, die von ansatzartigen Teilen 35 und 36 der p-Basisschicht 2 durchdrungen werden, welche bis zur Grenzfläche 5 reichen. In das ansatzartige Teil 35 ist ein ringförmiges n-leitendes Gebiet 37 eingefügt, das sich bis zur Grenzfläche 5 des Halbleiterkörpers erstreckt. In dieser wird es von einer leitenden Belegung 38 kontaktiert, die auch das ansatzartige Teil 35 kontaktiert, so dass der pn-Übergang zwischen dem ansatzartigen Teil 35 und dem ringförmigen Gebiet 37 am inneren Rand des letzteren niederohmig überbrückt wird. Zwischen dem Rand der Ausnehmung 33 und dem äusseren Rand des n-leitenden Gebiets 37 befindet sich ein ringförmiger Randbereich 35a des ansatzartigen Teils 35 der p-Basisschicht 2. Der Randbereich 35a ist von einer auf der Grenzfläche 5 aufgebrachten, dünnen, elektrisch isolierenden Schicht 39 überdeckt. Auf dieser ist ein Gate 40 aus elektrisch leitendem Material, z.B. Aluminium, aufgebracht, das mit einem Steueranschluss Ga verbunden ist.

Die Teile 1, 35a, 37, 39 und 40 bilden eine MIS-FET-Struktur M1a des Verarmungstyps, wobei der die Ausnehmung 33 begrenzende Bereich des n-Emitters 1 und das ringförmige Gebiet 37 jeweils ein erstes und ein zweites n-leitendes Halbleitergebiet darstellen, die durch einen aus dem Randbereich 35a bestehenden p-leitenden Halbleiterbereich voneinander getrennt sind. Bei spannungslosem Gate 40 ist in dem unmittelbar an der Grenzfläche 5 liegenden Teil des Randbereichs 35a ein n-leitender Kanal 41 vorhanden, der die Halbleitergebiete 1 und 37 niederohmig miteinander verbindet. Über die Teile 38, 37 und 41 verläuft ein Emitter-Kurzschlusspfad, der den pn-Übergang zwischen 1 und 2 niederohmig überbrückt. Bei dem Kanal 41 handelt es sich entweder um einen Inversionskanal, der durch ein an der Grenzfläche 5 herrschendes Feld hervorgerufen wird, oder um ein dotiertes Kanalgebiet (metallurgischer Kanal), das durch eine flache n-Dotierung in 35a eingefügt ist. Ist der Steueranschluss G1a mit einer negativen Spannung beschaltet, so wird der Kanal 41 beseitigt oder hochohmig geschaltet, so dass der Emitter-Kurzschlusspfad 38, 37 und 41 unwirksam ist.

In analoger Weise ist an der rechten Ausnehmung 34 eine MIS-FET-Struktur M2a gebildet, die aus einem in das ansatzartige Teil 36 eingefügten ringförmigen n-leitenden Gebiet 42, einem ringförmigen Randbereich 36a des ansatzartigen Teils 36, einer diesen überdeckenden isolierenden Schicht 43 und einem Gate 44 besteht. Das Gate 44 ist ebenfalls mit dem Steueranschluss G2a verbunden. Der pn-Übergang zwischen den Teilen 36 und 42 ist durch eine leitende Belegung 45 niederohmig überbrückt. Über die dem Verarmungstyp angehörende Struktur M2a verläuft ein Emitter-Kurzschlusspfad, der aus den Teilen 45, 42 und einem bei spannungslosem Gate 44 in dem Randbereich 36a vorhandenen Kanal 46 besteht. Bei dem Kanal 46 handelt es sich wie bei 41 um einen Inversionskanal oder um einen dotierten Kanal, der durch eine flache n-Dotierung an der Grenzfläche 5 gebildet ist. Die leitende Belegung 44 kann als Zündelektrode verwendet werden und ist in diesem Fall mit dem Anschluss Z des Zündstromkreises verbunden.

Ebenso wie die MIS-FET-Strukturen M1 und M2 können auch die Strukturen M1a und M2a quadratisch, sechseckig oder dergl. ausgeformt sein.

Die Elektrode G ist mit Ausnehmungen 47 und 48 versehen, die so dimensioniert sind, dass die Grenzfläche 5 im Bereich der Ausnehmungen 33 und 34 einschliesslich der diese begrenzenden Bereiche des n-Emitter 1 nicht kontaktiert wird.

Zur Zündung des Thyristors nach Fig. 10 wird dem Anschluss Z ein positiver Zündstromimpuls zugeführt. Die Ansteuerung einer Mehrzahl von MIS-FET-Strukturen M1a, M2a usw., die gleichmässig über den Thyristorquerschnitt verteilt sind, erfolgt nach einer ersten Schaltungsvariante über den einen gemeinsamen Steueranschluss Ga mittels einer Steuerspannung $-U_G$, die der Spannung nach Fig. 5 entspricht, jedoch ein entgegengesetztes Vorzeichen hat. Sämtliche Emitter-Kurzschlusspfade wirken dann als Stabilisierungskurzschlüsse. Bei MIS-FET-Strukturen des Anreicherungstyps ergibt sich die gleiche Wirkung, wenn die Ansteuerung durch eine Spannung $U_G'$ gemäss Fig. 6 unter Umkehrung des Vorzeichens erfolgt. Eine zweite Schaltungsvariante sieht eine erste Gruppe von MIS-FET-Strukturen des Verarmungstyps vor, z.B. M1a usw., die alle mit einem Steueranschluss G1a verbunden sind, und eine zweite, wesentlich grössere Gruppe von MIS-FET-Strukturen des Anreicherungstyps, z.B. M2a usw., die alle mit einem Steueranschluss G2a verbunden sind. Bei Zuführung von einer Spannung $U_G$ (vgl. Fig. 5) an G1a und von $-U_{G2}$ (vgl. Fig. 7) an G2a wirken die Kurzschlusspfade der ersten Gruppe als Stabilisierungs- und die Kurzschlusspfade der zweiten Gruppe als Löschkurzschlüsse.

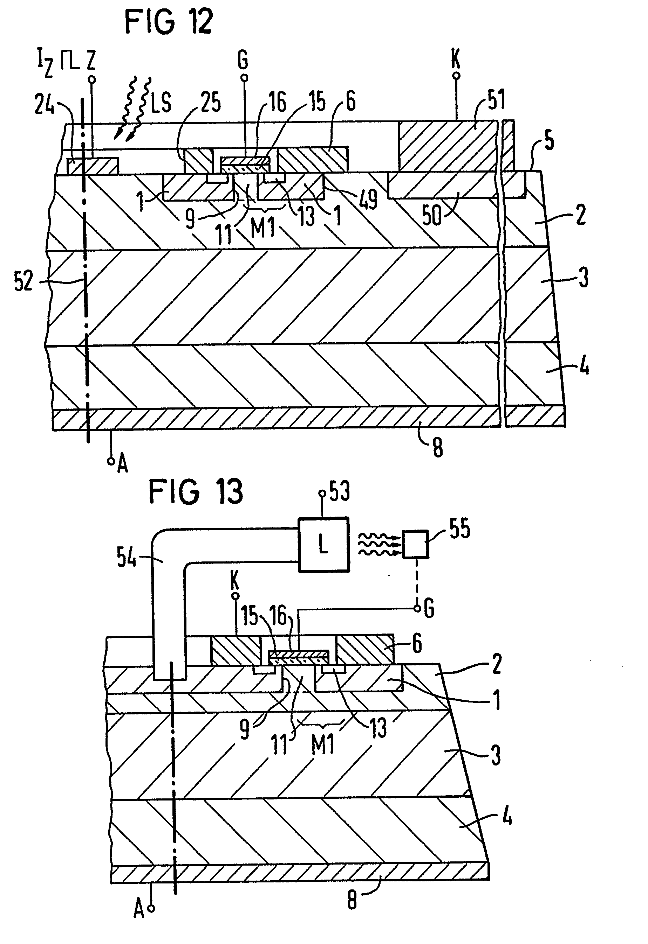

Fig. 12 zeigt ein Ausführungsbeispiel der Erfindung, bei dem die erste Elektrode 6 nicht wie bei den oben beschriebenen Thyristoren aus einer Kathode besteht, sondern aus einer Hilfsemitterelektrode (amplifying gate) eines mit innerer Stromverstärkung versehenen Thyristors. Hierbei kontaktiert die Elektrode 6 einen n-leitenden Hilfsemitter 1 und ist über dessen äusseren Rand 49 in Richtung auf einen n-Hauptemitter 50 verlängert. Der n-Hauptemitter 50 wird von einer Kathode 51 kontaktiert, die mit dem Anschluss K verbunden ist. Die zweite Elektrode 8 stellt wie bisher die Anode dar und weist einen Anschluss A auf. Der Thyristor nach Fig. 12 ist beispielsweise bezüglich einer Symmetrieachse 52 rotationssymmetrisch aufgebaut.

Eine Mehrzahl von MIS-FET-Strukturen, von denen in Fig. 12 nur eine dargestellt ist, wird bei einer Ausbildung entsprechend Fig. 1 über einen gemeinsamen Steueranschluss G mit der Spannung $U_G$ (bei Strukturen des Verarmungstyps) oder mit der Spannung $U_G'$ (bei Strukturen des Anreicherungstyps) beaufschlagt. Ihre Emitter-Kurzschlusspfade wirken dann als Stabilisierungskurzschlüsse des n-Hilfsemitters, die während jedes Zündvorgangs unwirksam gemacht werden. Statt einer Zündung durch einen Zündstromimpuls $I_Z$, der einer Zündelektrode 24 zugeführt wird, kann auch z.B. eine Zündung durch Lichtstrahlen LS erfolgen. Hierbei werden in einem Bereich der p-Basisschicht 2, der unterhalb der Ausnehmung 25 der Elektrode 6 liegt, durch die Lichteinwirkung Ladungsträger erzeugt, die zur Grenzfläche des n-Hilfsemitters 1 gelangen und eine Emission von Ladungsträgern aus dem n-Hilfsemitter in die Basisschichten bewirken, wodurch die Zündung eingeleitet wird.

Bei dem lichtzündbaren Thyristor nach Fig. 13 wird die zum Zünden benötigte Strahlung von einer steuerbaren Lichtquelle L erzeugt, die durch einen über einen Anschluss 53 zugeführten Zündstromimpuls zur Abgabe eines Lichtimpulses veranlasst wird. Dieser wird über einen Lichtleiter 54 zum lichtaktiven Bereich des Thyristors übertragen. In Fig. 13 stellt der n-Emitter 1 den Hauptemitter des Thyristors dar. Die Elektrode 6 ist mit dem Anschluss K verbunden und bildet die Kathode. Eine Mehrzahl von MIS-FET-Strukturen, die gemäss Fig. 1 ausgebildet sind, sind in den Hauptemitter 1 eingefügt. Bei Zuführung einer Spannung $U_G$ bzw. $U_G'$ an den Anschluss G wirken sie wieder als Stabilisierungskurzschlüsse. Die Spannung $U_G$ (Fig. 5) kann mit Vorteil über einen optoelektronischen Wandler 55 abgeleitet werden, der mit der Lichtquelle L in optischem Kontakt steht.

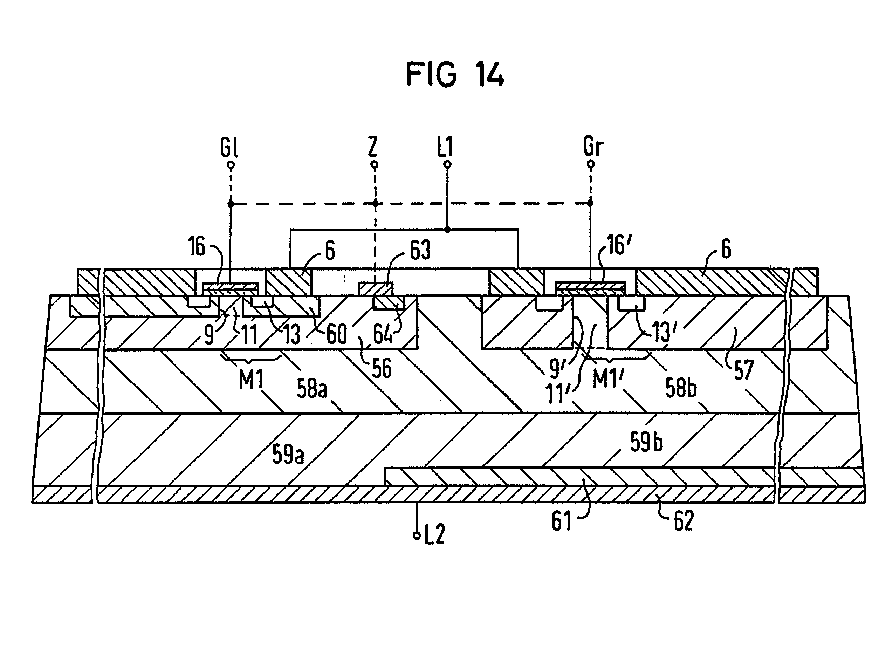

In Fig. 14 ist ein Triac dargestellt, der mehrere aufeinanderfolgende Halbleiterschichten abwechselnder Leitungstypen aufweist. Eine erste p-leitende Schicht bildet sowohl die p-Basisschicht 56 eines die linke Hälfte von Fig. 14 einnehmenden ersten Thyristors als auch einen p-Emitter 57 eines zweiten, in der rechten Hälfte von Fig. 14 dargestellten Thyristors. Eine an 56 und 57 angrenzende, n-leitende Schicht bildet die n-Basisschichten 58a und 58b beider Thyristoren, während die darunter liegende p-leitende Schicht den p-Emitter 59a des linken und die p-Basisschicht 59b des rechten Thyristors umfasst. In die p-Basisschicht 56 ist ein n-Emitter 60 des ersten Thyristors eingefügt, während in die Basisschicht 59b der n-Emitter 61 des zweiten Thyristors eingefügt ist. Der n-Emitter 60 wird von einer ersten Elektrode 6 kontaktiert, die mit einem Anschluss L1 versehen ist. Der p-Emitter 57 des rechten Thyristors wird ebenfalls von der ersten Elektrode 6 kontaktiert. Der p-Emitter 59a und der n-Emitter 61, sind mit einer zweiten Elektrode 62 belegt, die einen Anschluss L2 aufweist.

Auf der p-Basisschicht 56 ist eine Zündelektrode 63 vorgesehen. Sie kontaktiert sowohl die p-Basisschicht 56 als auch ein n-leitendes Steuergebiet 64, das in die Schicht 56 eingefügt ist. Die Zündelektrode 63 ist mit dem Anschluss Z eines Zündstromkreises verbunden.

In den n-Emitter 60 des linken Thyristors ist eine Mehrzahl von MIS-FET-Strukturen M1 des Verarmungstyps entsprechend Fig. 1 eingefügt, deren Gates mit einem Steueranschluss G1 verbunden sind. In den p-Emitter 57 des rechten Thyristors ist eine Mehrzahl von MIS-FET-Strukturen M1' eingefügt. Diese entsprechen den Strukturen M1, allerdings mit dem Unterschied, dass ihre Halbleitergebiete 57, 11', 13' die jeweils entgegengesetzten Leitungstypen zu den Gebieten 60, 11, 13 aufweisen. Das Gate 16' von M1' ist mit einem Steueranschluss Gr verbunden. Dabei befinden sich die MIS-FET-Strukturen vorzugsweise im Grenzgebiet beider Thyristoren.

An den Anschlüssen L1 und L2 liegt im Betrieb eine Wechselspannung. In einer Halbwelle, die L2 auf ein positiveres Potential legt als L1, zündet der linke Thyristor beim Zuführen eines positiven Zündstromimpulses über Z und bei einer Ansteuerung von G1 mit einem positiven Impuls während des Zündvorgangs (Fig. 5). In der nächstfolgenden Halbwelle zündet dann der rechte Thyristor bei Zuführung eines negativen Zündstromimpulses über Z und bei einer Ansteuerung von Gr mit einem negativen Impuls während des Zündvorgangs. Die Ansteuerung von G1 und Gr kann mit Hilfe der an Z auftretenden Zündspannung erfolgen, wenn beide Anschlüsse mit Z verbunden werden. Die MIS-FET-Strukturen M1 und M1' wirken als Stabilisierungskurzschlüsse und ermöglichen einen Betrieb des Triac bei hohen Kommutierungs-dU/dt-Werten.

Die Wirkung von steuerbaren Emitter-Kurzschlusspfaden bei Thyristoren entsprechend den Figuren 12 bis 14 ist eingehend in DE-A1-2 945 347, DE-A1-2 945 335 und DE-A1-2 945 380 beschrieben.

## Patentansprüche

1. Thyristor mit einem Halbleiterkörper, der einen von einer ersten Elektrode kontaktierten n-Emitter mit einer angrenzenden p-Basisschicht und einen von einer zweiten Elektrode kontaktierten p-Emitter mit einer angrenzenden n-Basisschicht aufweist, und mit an einer Grenzfläche des Halbleiterkörpers angeordneten MIS-FET-Strukturen, über die steuerbare Emitter-Kurzschlusspfade verlaufen, wobei die MIS-FET-Strukturen jeweils bestehen aus einem mit der ersten (zweiten) Elektrode verbundenen ersten Halbleitergebiet eines ersten Leitungstyps, einem mit einer Basisschicht verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate überdeckt ist, dadurch gekennzeichnet, dass der schichtförmige n(p)-Emitter (1) eine Mehrzahl von Ausnehmungen (9, 10) aufweist, in denen bis zur Grenzfläche (5) des Halbleiterkörpers reichende Teile (11) der p(n)-Basisschicht angeordnet sind, dass die Ränder der Ausnehmungen (9) des n(p)-Emitters (1) von den ersten Halbleitergebieten (13) der MIS-FET-Strukturen (M1) jeweils lateral umschlossen werden, dass die Ränder der Ausnehmungen (9) des n(p)-Emitters (1) ihrerseits die zweiten Halbleitergebiete (11) jeweils lateral umschliessen, dass die erste (zweite) Elektrode (6) Ausnehmungen (26, 27) aufweist, so dass die von den ersten Halbleitergebieten (13) jeweils lateral umschlossenen Teile der Grenzfläche (5) einschliesslich der an diese Teile angrenzenden Randbereiche der ersten Halbleitergebiete (13) von einer Kontaktierung durch die erste (zweite) Elektrode (6) ausgenommen sind, dass die p(n)-leitenden ersten Halbleitergebiete (13) in den n(p)-Emitter (1) eingefügt sind, dass die zweiten Halbleitergebiete aus ansatzartigen Teilen (11) der p(n)-Basisschicht (2) bestehen, die in den Ausnehmungen (9) des n(p)-Emitters angeordnet sind und dass die Halbleiterbereiche des zweiten Leitungstyps aus Randgebieten (14) des n(p)-Emitters (1) bestehen, die seine Ausnehmungen (9) unmittelbar umgeben.

2. Thyristor mit einem Halbleiterkörper, der einen von einer ersten Elektrode kontaktierten n-Emitter mit einer angrenzenden p-Basisschicht und einen von einer zweiten Elektrode kontaktierten p-Emitter mit einer angrenzenden n-Basisschicht aufweist, und mit an einer Grenzfläche des Halbleiterkörpers angeordneten MIS-FET-Strukturen, über die steuerbare Emitter-Kurzschlusspfade verlaufen, wobei die MIS-FET-Strukturen jeweils bestehen aus einem mit der ersten (zweiten) Elektrode verbundenen ersten Halbleitergebiet eines ersten Leitungstyps, einem mit einer Basisschicht verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate überdeckt ist, dadurch gekennzeichnet, dass der schichtförmige n(p)-Emitter (1) eine Mehrzahl von Ausnehmungen (33, 34) aufweist, in denen bis zur Grenzfläche (5) des Halbleiterkörpers reichende Teile (35, 36) der p(n)-Basisschicht angeordnet sind, dass die Ränder der Ausnehmungen (33, 34) des n(p)-Emitters (1) von den ersten Halbleitergebieten der MIS-FET-Strukturen (M1a, M2a) jeweils lateral umschlossen werden, dass die Ränder der Ausnehmungen (33, 34) des n(p)-Emitters (1) ihrerseits die zweiten Halbleitergebiete jeweils lateral umschliessen, dass die erste (zweite) Elektrode (6) Ausnehmungen (47, 48) aufweist, so dass die von den ersten Halbleitergebieten jeweils lateral umschlossenen Teile der Grenzfläche (5) einschliesslich der an diese Teile angrenzenden Randbereiche der ersten Halbleitergebiete von einer Kontaktierung durch die erste (zweite) Elektrode (6) ausgenommen sind, dass die ersten Halbleitergebiete aus Randgebieten des n(p)-Emitters (1) bestehen, die seine Ausnehmungen (33) unmittelbar umgeben, dass die zweiten Halbleitergebiete aus in sich geschlossenen n(p)-leitenden Gebieten (37) bestehen, die in ansatzartige Teile (35) der p(n)-Basisschicht (2) eingefügt sind und sich bis zur Grenzfläche (5) des Halbleiterkörpers erstrecken, wobei sie über leitende Belegungen (38) mit den ansatzartigen Teilen (35) der p(n)-Basisschicht (2) verbunden sind, und dass die Halbleiterbereiche des zweiten Leitungstyps aus Randgebieten (35a) der ansatzartigen Teile (35) der p(n)-Basisschicht (2) bestehen.

3. Thyristor nach einem der Ansprüche 1 oder 2, dadurch gekennzeichnet, dass die lateralen Begrenzungen der Ausnehmungen (9, 33) des n(p)-Emitters (1) kreisförmig, quadratisch oder sechseckig ausgeformt sind.

4. Thyristor nach einem der Ansprüche 1 bis 3, dadurch gekennzeichnet, dass die Gates zweier MIS-FET-Strukturen (M1′, M2′) über eine Leiterbahn (28) miteinander verbunden sind, die durch eine elektrisch isolierende Schicht (29) von dem Halbleiterkörper getrennt ist.

5. Thyristor nach einem der vorhergehenden Ansprüche, dadurch gekennzeichnet, dass die erste Elektrode (6) aus einer Hilfsemitterelektrode besteht.

6. Thyristor nach einem der Ansprüche 1 bis 4, dadurch gekennzeichnet, dass die erste Elektrode (6) aus einer Kathode oder Anode besteht.

7. Thyristor nach einem der vorhergehenden Ansprüche, dadurch gekennzeichnet, dass die MIS-FET-Strukturen in Ausnehmungen (9) des n(p)-Emitters angeordnet sind, die einem lichtaktiven Bereich seiner Basisschichten benachbart sind.

8. Triac, bestehend aus zwei Thyristoren nach einem der vorhergehenden Ansprüche, dadurch gekennzeichnet, dass die MIS-FET-Strukturen an den Rändern von Ausnehmungen des n-Emitters (60) des einen Thyristors und an den Rändern von Ausnehmungen (9′) des p-Emitters (57) des anderen Thyristors angeordnet sind und dass diese Ausnehmungen im wesentlichen im Grenzbereich beider Thyristoren liegen.

9. Verfahren zum Betrieb eines Thyristors nach einem der vorhergehenden Ansprüche, dadurch gekennzeichnet, dass die Gates (16, 21) aller MIS-FET-Strukturen (M1, M2) mit einer die Emitter-Kurzschlusspfade für die Dauer des Zündvorgangs abschaltenden Spannung (U$_G$) beaufschlagt werden.

10. Verfahren zum Betrieb eines Thyristors nach einem der Ansprüche 1 bis 8, dadurch gekennzeichnet, dass die Gates einer ersten Gruppe von MIS-FET-Strukturen (M1) mit einer ihre Emitter-Kurzschlusspfade für die Dauer des Zündvorgangs abschaltenden Spannung (U$_G$) beaufschlagt werden und dass die Gates einer zweiten, insbesondere wesentlich grösseren, Gruppe von MIS-FET-Strukturen (M2) mit einer ihre Emitter-Kurzschlusspfade nur für die Dauer des Löschvorgangs abschaltenden Spannung (U$_{G2}$) beaufschlagt werden.

**Claims**

1. A thyristor comprising a semiconductor body which has an n-emitter contacted by a first electrode, with an adjoining p-base layer which has a p-emitter contacted by a second electrode, with an adjacent n-base layer, and MIS-FET-structures arranged at a boundary surface of the semiconductor body and through which controllable emitter short circuit paths extend, where the MIS-FET-structures each consist of a first semiconductor zone of a first conductivity type which is connected to the first (second) electrode, of a second semiconductor zone of the first conductivity type which is connected to a base layer, and of a semiconductor zone of a second conductivity type which is located between these semiconductor zones and which is covered by a gate which is electrically insulated from the semiconductor body, characterised in that the layer-form n(p)-emitter (1) contains a plurality of openings (9, 10) in which are arranged parts (11) of the p(n)-base layer which extend to the boundary surface (5) of the semiconductor body; that the edges of the openings (9) in the n(p)-emitter (1) are in each case laterally enclosed by the first semiconductor zones (13) of the MIS-FET-structures (M1); that the edges of the openings (9) of the n(p)-emitter (1) themselves in each case laterally enclose the second semiconductor zones (11); that the first (second) electrode (6) contains openings (26, 27), so that those parts of the boundary surface (5) which are in each case laterally enclosed by the first semiconductor zones (13), including the edge zones of the first semiconductor zones (13) which adjoin these parts, are excluded from contacting by the first (second) electrode (6); that the p(n)-conducting, first semiconductor zones (13) are inserted into the n(p)-emitter (1); that the second semiconductor zones consist of shouldered parts (11) of the p(n)-base layer (2) which are located in the openings (9) in the n(p)-emitter; and that the semiconductor zones of the second conductivity type consist of edge zones (14) of the n(p)-emitter (1) which directly surround the openings (9) thereof.

2. A thyristor comprising a semiconductor body which has an n-emitter contacted by a first electrode, with an adjacent p-base layer which has a p-emitter contacted by a second electrode, with an adjacent n-base layer, and MIS-FET-structures arranged at a boundary surface of the semiconductor body and through which controllable emitter short circuit paths extend, where the MIS-FET-structures each consist of a first semiconductor zone of a first conductivity type which is connected to the first (second) electrode, of a second semiconductor zone of the first conductivity type which is connected to a base layer, and of a semiconductor zone of a second conductivity type which is located between these semiconductor zones and which is covered by a gate which is electrically insulated from the semiconductor body, characterised in that the layer-form n(p)-emitter (1) contains a plurality of openings (33, 34) in which are arranged parts (35, 36) of the p(n)-base layer which extend to the boundary surface (5) of the semiconductor body; that the edges of the openings (33, 34) in the n(p)-emitter (1) are in each case laterally enclosed by the first semiconductor zones of the MIS-FET-structures (M1a, M2a); that the edges of the openings (33, 34) in the n(p)-emitter (1) themselves in each case laterally enclose the second semiconductor zones; that the first (second) electrode (6) contains openings (47, 48), so that those parts of the boundary surface (5) which are in each case laterally enclosed by the first semiconductor zones, including the edge zones of the first semiconductor zones which adjoin these parts, are excluded from contacting by the first (second) electrode (6); that the first semiconductor zones consist of edge zones of the n(p)-emitter (1) which directly surround the openings (33) therein; that the second semiconductor zones consist of n(p)-conducting zones (37) closes in themselves which are inserted into shouldered parts (35) of the p(n)-base layer (2) and extend to the boundary surface (5) of the semiconductor body where they are connected through conductive coatings (38) to the shouldered parts (35) of the p(n)-base layer (2); and that the semiconductor zones of the second conductivity type consist of edge zones (35a) of the shouldered parts (35) of the p(n)-base layer (2).

3. A thyristor as claimed in one of Claims 1 or 2, characterised in that the lateral boundaries of the openings (9, 33) in the n(p)-emitter (1) are of circular, square or hexagonal shape.

4. A thyristor as claimed in one of Claims 1 to 3, characterised in that the gates of two MIS-FET-structures (M1', M2') are connected to one another through a conductor path (28) which is isolated from the semiconductor body by an electrically insulating layer (29).

5. A thyristor as claimed in one of the preceding Claims, characterised in that the first electrode (6) consists of an auxiliary emitter electrode.

6. A thyristor as claimed in one of Claims 1 to 4, characterised in that the first electrode (6) consists of a cathode or anode.

7. A thyristor as claimed in one of the preceding Claims, characterised in that the MIS-FET-structures are located in openings (9) in the n(p)-emitter which are adjacent to a light-active region of its base layers.

8. A triac consisting of two thyristors as claimed in one of the preceding Claims, characterised in that the MIS-FET-structures are arranged at the edges of openings in the n-emitter (60) of the first thyristor and at the edges of openings (9') in the p-emitter (57) of the other thyristor; and that these openings are essentially located in the boundary region of the two thyristors.

9. A method of operating a thyristor as claimed in one of the preceding Claims, characterised in that the gates (16, 21) of all the MIS-FET-structures (M1, M2) have applied thereto a voltage ($U_G$) which disconnects the emitter short circuit paths for the duration of the firing process.

10. A method of operating a thyristor as claimed in one of the Claims 1 to 8, characterised in that the gates of a first group of MIS-FET-structures (M1) have applied thereto a voltage ($U_G$) which disconnects their emitter short circuit paths for the duration of the firing process; and that the gates of a second, in particular but not essentially a substantially larger, group of MIS-FET-structures (M2) have applied thereto a voltage ($U_{G2}$) which disconnects their emitter short circuit paths only for the duration of the extinguishing process.

**Revendications**

1. Thyristor possédant un corps semi-conducteur qui présente un émetteur n, avec une couche de base p voisine, mis en contact avec une première électrode, et un émetteur p, avec une couche de base n voisine, mis en contact avec une seconde électrode, et qui présente des structures MIS-FET, disposées à une surface limite du corps semi-conducteur, par lesquelles passent des chemins de court-circuit d'émetteur pouvant être commandés, chacune des structures MIS-FET étant constituées d'une première région de semi-conducteur, d'un premier type de conductivité, qui est reliée à la première (seconde) électrode, d'une deuxième région de semi-conducteur, du premier type de conductivité, reliée à une couche de base, et d'une région de semi-conducteur, d'un second type de conductivité, située entre ces régions et recouverte par une grille électriquement isolée par rapport au corps semi-conducteur, caractérisé en ce que l'émetteur n(p), en forme de couche, présente plusieurs évidements (9, 10), dans lesquels sont disposées des parties (11) de la couche de base n(p) s'étendant jusqu'à la surface limite (5) du corps semi-conducteur, que les bords des évidements (9) de l'émetteur n(p) (1) sont latéralement enfermés chacun par les premières régions (13) des structures MIS-FET (M1), que les bords des évidements (9) de l'émetteur n(p) (1) enferment eux-mêmes, latéralement, chacune des deuxièmes régions (11), que la première (seconde) électrode (6) présente des fenêtres (26, 27), de manière que les parties de la surface limite (5) enfermées latéralement par les premières régions (13), y compris les zones marginales, limitrophes à ces parties, des premières régions (13), soient exclues de la mise en contact avec la première (seconde) électrode (6), que les premières régions (13), de conductivité p(n), sont insérées dans l'émetteur n(p) (1), que les deuxièmes régions sont constituées par des parties en forme de saillies (11) de la couche de base p(n) (2), disposées dans les évidements (9) de l'émetteur n(p), et que les régions du second type de conductivité sont des zones marginales (14) de l'émetteur n(p) (1), qui entourent directement les évidements (9) de celui-ci.

2. Thyristor possédant un corps semi-conducteur qui présente un émetteur n, avec une couche de base p voisine, mis en contact avec une première électrode, et un émetteur p, avec une couche de base n voisine, mis en contact avec une seconde électrode, et qui présente des structures MIS-FET, disposées à une surface limite du corps semi-conducteur, par lesquelles passent des chemins de court-circuit d'émetteur pouvant être commandés, chacune des structures MIS-FET étant constituées d'une première région de semi-conducteur, d'un premier type de conductivité, qui est reliée à la première (seconde) électrode, d'une deuxième région de semi-conducteur, du premier type de conductivité, reliée à une couche de base, et d'une région de semi-conducteur, d'un second type de conductivité, située entre ces régions et recouverte par une grille électriquement isolée par rapport au corps semi-conducteur, caractérisé en ce que l'émetteur n(p) (1), en forme de couche, présente plusieurs évidements (33, 34), dans lesquels sont disposées des parties, (35, 36) de la couche de base n(p) s'étendant jusqu'à la surface limite (5) du corps semi-conducteur, que les bords des évidements (33, 34) de l'émetteur n(p) (1) sont latéralement enfermés chacun par les premières régions des structures MIS-FET (M1a, M2a), que les bords des évidements (33, 34) de l'émetteur n(p) (1) enferment eux-mêmes, latéralement, chacune des deuxièmes régions, que la première (seconde) électrode (6) présente des fenêtres (47, 48), de manière que les parties de la surface limite (5) enfermées latéralement par les premières régions, y compris les zones marginales, limitrophes à ces parties des premières régions, soient exclues de la mise en contact avec la première (seconde) électrode (6), que les premières régions sont constituées par des régions marginales de l'émetteur n(p) (1), qui entourent directement les évidements (33) de celui-ci, que les deuxièmes régions sont des régions n(p) (37) fermées en elles-mêmes, qui sont insérées dans des parties formant des saillies (35) de la couche de base p(n) (2) et s'étendent jusqu'à la surface limite (5) du corps semi-conducteur, en étant reliées par des revêtements conducteurs (38) aux saillies (35) de la couche de base p(n) (2), et que les régions du second type de conductivité sont des zones marginales (35a) des saillies (35) de la couche de base p(n) (2).

3. Thyristor selon la revendication 1 ou 2, caractérisé en ce que les limites latérales des évidements (9, 33) de l'émetteur n(p) (1) sont circulaires, carrées ou hexagonales.

4. Thyristor selon une des revendications 1 à 3, caractérisé en ce que les grilles de deux structures MIS-FET (M1', M2') sont connectées l'une à l'autre par une piste conductive (28) qui est séparée par une couche électriquement isolante (29) du corps semi-conducteur.

5. Thyristor selon une des revendications précédentes, caractérisé en ce que la première électrode (6) est une électrode d'émetteur auxiliaire.

6. Thyristor selon une des revendications 1 à 4, caractérisé en ce que la première électrode (6) est une cathode ou une anode.

7. Thyristor selon une des revendications précédentes, caractérisé en ce que les structures MIS-FET sont disposées dans des évidements (9) de l'émetteur n(p), qui sont proches d'une zone active photosensible de ses couches de base.

8. Triac constitué de deux thyristors selon une des revendications précédentes, caractérisé en ce que les structures MIS-FET sont disposées sur les bords d'évidements de l'émetteur n (60) d'un thyristor et sur les bords d'évidements (9') de l'émetteur p (57) de l'autre thyristor et que ces évidements sont situés essentiellement dans la zone limite des deux thyristors.

9. Procédé pour l'utilisation d'un thyristor selon une des revendications précédentes, caractérisé en ce que les grilles (16, 21) de toutes les structures MIS-FET (M1, M2) sont soumises à une tension $(U_G)$ qui coupe les chemins de court-circuit d'émetteur pendant la durée du processus d'amorçage.

10. Procédé pour l'utilisation d'un thyristor selon une des revendications 1 à 8, caractérisé en ce que les grilles d'un premier groupe de structures MIS-FET (M1) sont soumises à une tension $(U_G)$ coupant leurs chemins de court-circuit d'émetteur pendant la durée du processus d'amorçage et que les grilles d'un second groupe, en particulier d'un second groupe nettement plus grand, de structures MIS-FET (M2) sont soumises à une tension $(U_{G2})$ qui coupe leurs chemins de court-circuit d'émetteur uniquement pendant la durée du processus d'extinction.

# FIG 1

# FIG 2

# FIG 3

16'  6

13'

26'

9'

# FIG 4

6  16"  9"

26"

13"

# FIG 5

$U_G$

+5V — P1

t1  t2   t

# FIG 6

$U_G'$

t1  t2   t

-5V

# FIG 7

$U_{G2}$

t3  t4   t

-5V   P2

## FIG 8

IV –·· –·                                                                                      –·· – IV

6    16'    30    16a'    6

M1'    28    29    M2'

## FIG 9

16'    16a'

31    G(G1)
32
III –· – · –                                                                           –· – · – III

6

28    29

## FIG 10

G1a    K    Ga    Z    G2a

47  6    35  38  40  39  41  6    42  45  42  44  43  48  6
VI                                                                    VI

37  35a  33    1    36  36a  46  34    5  1  2

M1a                              M2a                              3

4

A    8

## FIG 11

6

38  37  40  33    45  42  44  34

V —··—                                              —·—V

## FIG 12

## FIG 13

# FIG 14

0 064 715